(19) **Europäisches Patentamt / European Patent Office / Office européen des brevets**

(11) **EP 2 898 534 B1**

(12) **EUROPEAN PATENT SPECIFICATION**

(45) Date of publication and mention of the grant of the patent:
**24.11.2021  Bulletin 2021/47**

(21) Application number: **13815134.5**

(22) Date of filing: **30.08.2013**

(51) Int Cl.:
*H01L 31/02* [(2006.01)]     *H01L 31/052* [(2014.01)]
*H01L 31/0216* [(2014.01)]   *G02B 5/28* [(2006.01)]
*C03C 17/34* [(2006.01)]     *F24S 80/52* [(2018.01)]

(86) International application number:
**PCT/IB2013/058158**

(87) International publication number:
**WO 2014/045144 (27.03.2014 Gazette 2014/13)**

(54) **INTERFERENCE FILTER WITH ANGULAR INDEPENDENT ORANGE COLOUR OF REFLECTION AND HIGH SOLAR TRANSMITTANCE, SUITABLE FOR ROOF-INTEGRATION OF SOLAR ENERGY SYSTEMS**

INTERFERENZFILTER MIT WINKELUNABHÄNGIGER ORANGER REFLEXIONSFARBE UND HOHER SONNENSTRAHLUNGSDURCHLÄSSIGKEIT FÜR DACHINTEGRIERTE SONNENENERGIESYSTEME

FILTRE D'INTERFÉRENCE À COULEUR DE RÉFLEXION ORANGE INDÉPENDANTE ANGULAIRE ET NIVEAU DE TRANSMISSION SOLAIRE ÉLEVÉ, CONVENANT À L'INTÉGRATION EN TOITURE DE SYSTÈMES D'ÉNERGIE SOLAIRE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **20.09.2012  PCT/IB2012/054998**

(43) Date of publication of application:
**29.07.2015  Bulletin 2015/31**

(73) Proprietor: **École Polytechnique Fédérale de Lausanne (EPFL)**
**1015 Lausanne (CH)**

(72) Inventors:
• **SCHÜLER, Andreas**
  **1018 Lausanne (CH)**

• **JOLY, Martin**
  **1006 Lausanne (CH)**
• **HODY LE CAËR, Virginie**
  **1030 Bussigny-près-Lausanne (CH)**

(74) Representative: **Grosfillier, Philippe**
**ANDRE ROLAND S.A.**
**IP Attorneys & Services**
**Avenue Collonges 21**
**1004 Lausanne (CH)**

(56) References cited:
**EP-A1- 1 176 434      EP-A2- 0 983 972**
**EP-A2- 2 051 124      WO-A1-2004/079278**
**US-A1- 2011 268 941**

• **None**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

**Field of the invention**

The invention relates to an orange-coloured glazing particularly, but not exclusively, suitable for roof solar systems such as photovoltaic modules and tiles, thermal or hybrid photovoltaic-thermal collectors and passive systems. The colour is obtained by the deposition on the inner side of the glazing of a multi-layered interferential coating. This coating is designed to reflect a narrow spectral band of the visible light while being transparent for the rest of the solar spectrum and thus guaranteeing limited or negligible loss of efficiency of the mentioned systems.

**Definitions**

**Direct transmittance**

If parallel beams of radiation incident on a surface, an interface, or a specimen result in transmitted parallel beams, the transmittance is considered as direct. This is the case e.g., for flat surfaces or interfaces.

**Diffuse transmittance**

If parallel beams of radiation incident on a surface, an interface, or a specimen result in a more or less wide angular distribution of transmitted beams, the transmittance is considered as diffuse. This is the case e.g., for rough surfaces or interfaces, or for specimens of granular structure.
In general, the diffuse transmittance depends on the angle of incidence and the wavelength λ of the radiation. If the angle of incidence is not explicitly mentioned, commonly normal incidence is assumed.

**Total hemispherical transmittance**

The total hemispherical transmittance is obtained by the sum of direct transmittance and diffuse transmittance.

$$T_{total} = T_{direct} + T_{diffuse}$$

In general, the total hemispherical transmittance depends on the angle of incidence and the wavelength λ of the radiation. If the angle of incidence is not explicitly mentioned, commonly normal incidence is assumed.

**Solar transmittance T$_{sol}$**

Given a calculated or measured spectrum of the total hemispherical transmittance of a sample $T(\lambda)$, the solar transmittance **T$_{sol}$** is obtained by integration with the solar spectrum $I_{sol}(\lambda)$:

$$T_{sol} = \frac{\int T(\lambda) \cdot I_{sol}(\lambda) d\lambda}{\int I_{sol}(\lambda) d\lambda}$$

where usually the solar spectrum at air mass 1.5 (AM1.5) is employed as intensity $I_{sol}(\lambda)$.

**Visible reflectance R$_{vis}$**

The visible reflectance R$_{vis}$ is a measure for the brightness of a surface as it appears to the human eye under certain illumination conditions. A white surface or a perfect mirror exhibits 100% visible reflectance, coloured or grey surfaces less. The determination of the visible reflectance R$_{VIS}$ is based on the photopic luminous efficiency function $V(\lambda)$ and depends on the choice of the illuminant $I_{ILL}(\lambda)$:

$$R_{vis} = \frac{\int R(\lambda) \cdot I_{ILL}(\lambda) \cdot V(\lambda) d\lambda}{\int I_{ILL}(\lambda) \cdot V(\lambda) d\lambda}$$

where R($\lambda$) is the simulated or measured hemispherical reflectance of the sample.

## Angle of reflection

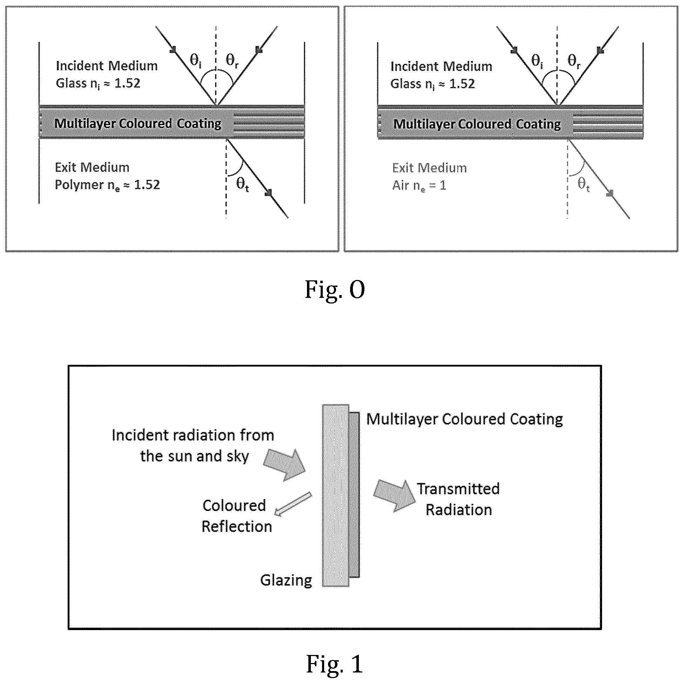

The angle of reflection $\theta_r$ is the angle formed by a ray of light reflected from a surface and a line perpendicular to the surface at the point of reflection. Here $\theta_l$ and $\theta_t$ correspond respectively to the incidence and transmission angles. (see Figure 0)

## Refractive index and extinction coefficient

When light passes through a medium, some part of it will always be absorbed. This can be conveniently taken into account by defining a complex index of refraction N:

$$N = n - ik \qquad [1]$$

where the real part n (refractive index) indicates the phase speed, while the imaginary part k (extinction coefficient) indicates the amount of absorption loss when the electromagnetic wave propagates through the material.

## CIE 1931 XYZ colour space

The International Commission on Illumination (CIE, Commission Internationale d'Eclairage) described how to quantify colours [2]. All existing colours can be represented in a plane and mapped by Cartesian coordinates, as shown in the CIE Chromaticity Diagrams. The quantification is based on the 1931 CIE Colour Matching Functions, x($\lambda$), y($\lambda$), and z($\lambda$), which reflect the colour sensitivity of the human eye. These functions depend to some extent on the width of the observation field (we will use the functions for an opening angle of 2°).

## CIE 1976 (L*, a*, b*) colour space (or CIELAB)

CIE L*a*b* is the most complete colour model used conventionally to describe all the colors visible to the human eye. It was developed for this specific purpose by the International Commission on Illumination (Commission Internationale d'Eclairage).
The three parameters in the model represent the lightness of the colour (L*, L*=0 yields black and L*=100 indicates white), its position between magenta and green (a*, negative values indicate green while positive values indicate magenta) and its position between yellow and blue (b*, negative values indicate blue and positive values indicate yellow).

## Colour stability

The colour differences $\Delta E^*$ between two different angles are simply be calculated as the Euclidean distance between two colour points whose colour coordinates are respectively $(a_1^*, b_1^*, L_1^*)$ and $(a_2^*, b_2^*, L_2^*)$ in the CIE 1976 Lab colour space.
This difference is calculated as:

$$\Delta E^* = \sqrt{(a_2^* - a_1^*)^2 + (b_2^* - b_1^*)^2 + (L_2^* - L_1^*)^2}$$

$\Delta E_{Norm}^*$ refers to the difference in colour coordinates at an off-normal angle of reflection $\theta_r$ ($\theta_r > 10°$) with respect to near-normal angle of reflection ($\theta_r \leq 10°$).

## State of the art

As the need for alternative fuels to coal evolves, harnessing the power of the sun has become a sustainable means of generating energy. Incorporating solar energy systems into homes and building would indeed permit to achieve long-term energy independence, while reducing environmental impact. Solar technologies are broadly characterized as either passive solar or active solar depending on the way they capture, convert and distribute solar energy.

Passive solar systems are used to optimise the amount of energy that can be derived directly from the sun, by careful planning of buildings to collect the sun's heat, thus reducing the need for heating. Simple features can be incorporated at the design stage such as large south-facing windows and building materials that absorb and slowly release the sun's heat. Two other design features that help provide passive solar energy are sunspaces and trombe walls. Sunspaces (similar to a greenhouse) are constructed on the south side of a building. As sunlight passes through the glass or glazing it warms the sunspace. Proper ventilation allows the heat to circulate into the building.

A trombe wall is a thick, south-facing wall, painted black and capable of absorbing a lot of heat. A pane of glass or plastic glazing, installed a few inches in front of the wall, helps hold in the heat. The wall heats up slowly during the day. Then as it cools gradually during the night, it gives off its heat inside the building. However, the use of such passive solar system into houses and building is difficult or impossible since not all spaces might have a south-facing facade.

Active solar systems use electrical or mechanical equipment such as solar photovoltaic (PV), solar thermal (ST) and solar PV-thermal (PVT) hybrid panels to convert the solar energy into heat or electricity.

Solar photovoltaic systems converting the energy of the sun into electrical energy thanks to PV modules made of different types of solar cells converting up to 20% of the incident solar energy into electricity are used. Most common cells include materials such as mono-crystalline silicon, microcrystalline silicon (mc-Si), amorphous silicon (a-Si), cadmium telluride (CdTe) or copper indium gallium selenide (CIGS). These cells are electrically connected, sandwiched by encapsulation between two glasses or polymer sheets (most commonly Tedlar). The first sheet is used as the rear of the panel whereas the other one constitutes the front surface of the modules. The second one protects the cells from exposure to the environment and is ideally chosen to allow a high transmission of incident solar energy.

Solar thermal (ST) systems use the heat collected from solar energy for hot water production, domestic heating and more recently air-conditioning. The thermal collectors are essentially composed of absorbers (black metal plates or evacuated tubes) which are heated by the sunlight and transfer the collected heat to a circulating fluid (air, water or other fluid). The absorbers are frequently placed into a glazed insulated box in order to create a greenhouse effect and consequently, to maximise the yield of this hot water heating system.

PVT collectors are hybrid systems that combine photovoltaic energy generation with thermal heating capabilities in one module. Basically these modules consist of PV-laminate that functions as the absorber of a thermal collector. The heat from the PV cells are conducted through the metal and absorbed by the working fluid.

Solar panels and collectors are generally installed on roof surface, which is generally located above the "shade line" for trees and adjacent structures, offering unobstructed access to available solar energy and thus a maximal efficiency. The solar devices are mounted on racking systems that fit on a typical roof, solar panels and collectors can often be assimilated to a flat, rectangular box with a transparent cover that faces the sun.

As architectural integration of solar energy systems into buildings has become a widely recognized issue [3-6], many efforts have been made to enhance the visual aspect of the solar devices and to develop new building-integrated products. Nowadays few BIPV (building-integrated photovoltaic) systems where the PV system essentially becomes an integral part of the building envelope are commercially available. For example, solar tiles where photovoltaic cells are mounted to traditional slate roofing tiles can be found on the market. New solar roofing BIPV but also BIPVT (building-integrated PV-thermal) modules, replacing several standard concrete tiles (instead of snapping onto regular roofing tile) and compatible with most shapes and sizes of roof tiles used in new residential construction, are also available. BIST (building-integrated solar thermal) systems have been studied to a lesser extent and have generally been developed for facade integration.

Despite these improvements, the architectural integration of solar systems into buildings could be further improved. Indeed, most of solar modules and collectors still use standard or textured glazing. The resulting dark appearance combined to the inability to completely hide the technical parts of the collectors (absorber metallic sheets, tubes...) or modules (cells, contacts...) still limits the architectural integration. Few years ago an opinion poll showed that 85% of architects are interested in better-looking collectors, even if a lower efficiency was the price to pay [7].

One option to overcome this drawback is to apply a coloured interferential thin film to the inner side of the collector glazing. The coating reflects a colour, thus hiding the technical part of the system, but transmits the complementary spectrum (see Figure 1).

Preferably, but not exclusively, multilayer interference stacks of transparent materials obtained by alternating layers of high and low refractive indices, are ideally suited for this purpose.

An optical multilayer of plane-parallel thin films on a substrate can be considered as a stratified medium. The propagation of electromagnetic waves in stratified media has been discussed by Born and Wolf [8]. The field of optics of thin films has been reviewed by various authors, e.g. Heavens [9], Holland [10], Anders [11], Knittl [12], and Macleod [13]. Due to the multiple reflections between the different interfaces, the problem of the optical behaviour of a multilayered thin film stack is non-trivial. It can be treated, though, by the method of characteristic matrices, which defines one matrix per individual layer. From this matrix product, transmission and reflectance spectra can be computed. Extended calculations are usually carried out by a computer with designed software such as TFCalc. Complete descriptions of the method can be found in references [14-17].

US2011268941 A1 discloses a process for manufacturing at least one substrate, especially transparent glass substrates, each provided with a thin-film multilayer comprising an alternation of "n" metallic functional layers especially of functional layers based on silver or a metal alloy containing silver, and of "(n+1)" anti-reflection coatings, with n being an integer $\geqq$ 3, each antireflection coating comprising at least one antireflection layer, so that each functional layer is positioned between two antireflection coatings, said thin-film multilayer being deposited by a vacuum technique, said multilayer being such that the thicknesses of two functional layers at least are different and the thicknesses of the functional layers have a symmetry within the multilayer relative to the center of the multilayer. WO2004079278 A1 discloses a glazing designed to reflect a narrow spectral band of visible light while being transparent for the rest of the solar spectrum. The glazing is particularly, but not exclusively, suitable for solar collectors.

EP0983972 A2 discloses a solar-control glass that has acceptable visible light transmission,absorbs near infrared wavelength light (NIR) and reflects midrange infrared light (low emissivity mid IR) along with a preselected color within the visible light spectrum for reflected light is provided. Also disclosed is a method of producing the improved, coated, solar-controlled glass. The improved glass has a solar energy (NIR) absorbing layer comprising tin oxide having a dopant such as antimony and a low emissivity control layer (low emissivity) capable of reflecting midrange infrared light and comprising tin oxide having fluorine and/or phosphorus dopant. A separate iridescence color suppressing layer is generally not needed to achieve a neutral (colorless) appearance for the coated glass, however an iridescence suppressing layer or other layers may be combined with the two-layer assemblage. If desired, multiple solar control and/or multiple low emissivity layers can be utilized. The NIR layer and the low emissivity layer can be separate portions of a single tin oxide film since both layers are composed of doped tin oxide. A method of producing the coated solar control glass is also disclosed.

EP1176434 A1 discloses a substrate provided with antireflection films for light incident at an oblique angle from the film face side, which has a high transmittance and with which the reflection color tone does not tend to be bluish, comprising a transparent substrate and at least two antireflection film layers deposited on one side of the transparent substrate.

The use of interference filters on thermal collector glazing has been the subject of a PCT application in 2004 [18]. Multilayer designs obtained had however two major drawbacks:

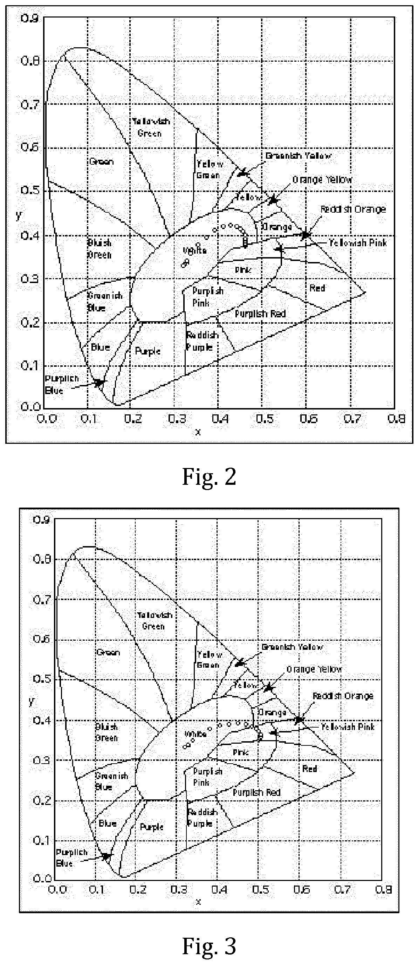

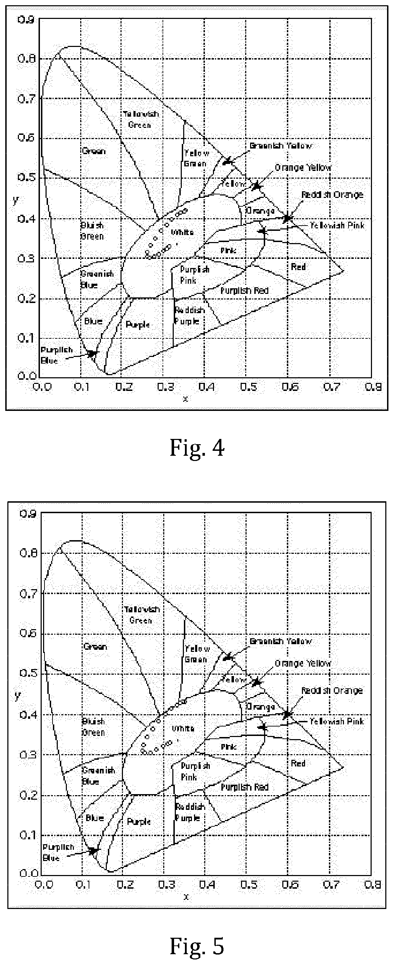

- As already mentioned in [18], these layers had a strong angular dependence of the colour, i.e. a strong colour change with increasing angle of reflection $\theta_r$. As presented for Examples 1, 2, 3 and 4 (see Figures 2, 3, 4, 5 and Tables 1, 2, 3, 4 and 5), yellowish to reddish-orange designs developed in 2004 are characterised by $\Delta E^*_{Norm} > 25$ for an angle of reflection $\theta_r = 60°$.

- The most angular-stable developed colour (blue) was not suitable for solar systems mostly installed on roofs of predominantly grey or orange colour.

Innovation presented here relates to coloured multi-layered interferential coating that matches to the colour of most tiles used on residential buildings, thus promoting the architectural integration of solar systems. As grey filters are easy to produce, special attention has been given to the development of orange-coloured coatings which are the subject of this invention.

These coatings characterized by:

- A coloured visible reflection from yellowish-orange to reddish-orange intense enough to mask the technical part of modules and collectors

- A good stability of colour with varying viewing angle

- A high solar transmittance to ensure a good efficiency of solar systems

Those objectives are achieved with the glazing according to the present innovation which, preferably but not exclusively, comprises the deposition of multilayer interference stacks of non-absorbing transparent materials such as $ZnO$, $SiO_2$, $Al_2O_3$, $MgF_2$, $CaF_2$... Those coatings can be deposited by various techniques (e.g. magnetron sputtering, evaporation, sol-gel...) on the inner side of the glazing consisting e.g. of extra-white glass (very low iron content) or organic material such as Tedlar.

**General description of the invention**

The problems mentioned in the previous chapter have been solved with the present invention which relates to a solar glazing unit as defined in claim 1.

In the present text, the CIE Colour stability $\Delta E^*_{Norm}$ refers to the difference in colour coordinates at an off-normal angle of observation $\theta_r$ ($\theta_r > 10°$) with respect to near-normal angle of observation ($\theta_r \leq 10°$).

The optical behaviour of multi-layered thin film stacks is described by well-known but complicated formulae. Each individual layer is represented by a $2 \times 2$ matrix, the multi-layered stack by their matrix product. Multiple reflections from back and front side of the glass have to be taken into account. Due to the complexity of the equations, numerical simulations are usually performed with the aid of a computer. Software performing these calculations is already commercially available. A professional tool for designing interference filters is TFCalc, which also includes the features of refining an existing design and even a global search for optimal designs.

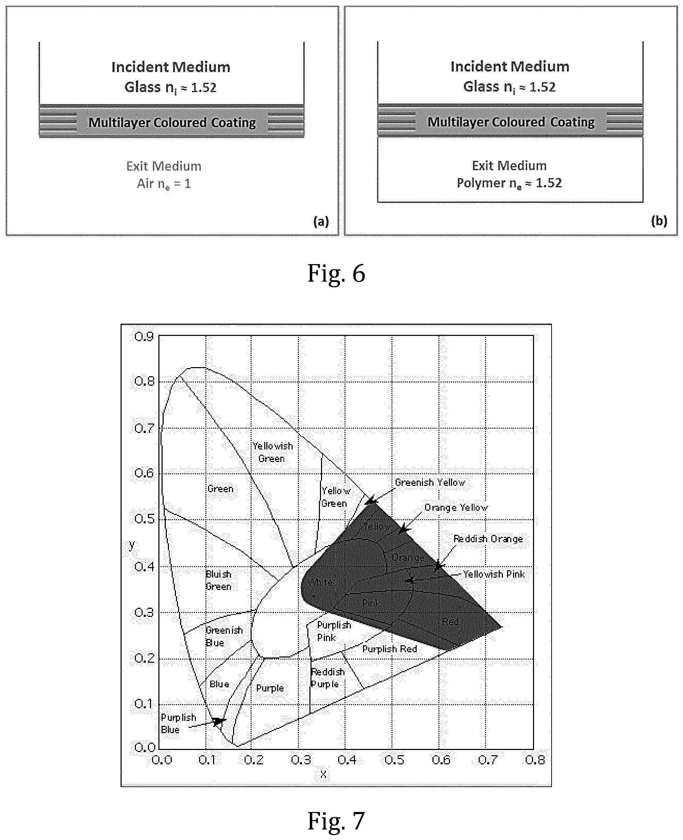

The two models used for the simulations, depending of the considered solar system, are presented in Figure 6. Regarding ST, PVT and passive systems, exit medium used for simulations is air whereas it is polymer for PV systems. In both cases, the substrate to be coated is preferably, but non-exclusively, glass. Solar glazing is nearly iron-free, which ensures low absorption in the bulk glass. Typical refractive indices exhibit normal dispersion in the range of 1.51 < n < 1.58 (at 500 nm: n = 1.52 for BK7, n = 1.54 for AF45). For the simulations a 4mm-thick extra-white (almost iron free) glass is considered.

For the present invention the choice of the constituent materials of the coating must be realistic, and the considered refractive indices have consequently to be within a certain range, given that in most cases the refractive indices depend to a large extend on the deposition conditions.

Because the constraints that no absorption must occur, the use of thin films built up of transparent materials such as e.g. $ZnO$, $SiO_2$, $Al_2O_3$, $MgF_2$ or $CaF_2$ is preferable. Some commonly used thin film materials, taken in consideration in the context of the invention are listed in Table 6. Of course, many more materials are available, especially if composite materials permitting to achieve intermediate refractive indices are taken into consideration (e.g. silicon titanium oxide obtained by mixing $SiO_2$ and $TiO_2$ [19].

In addition, the maximum number individual layers building the multilayer stack in the present invention is limited to a number of 9. As a matter of facts, in contrast to applications such as laser interference filters, solar applications employ typically large surfaces to be coated at low price. The number of individual layers building the multilayer stack is then limited by the production costs.

Regarding colorimetry, the Commission Internationale d'Eclairage (CIE) describes standard illuminants (like A, B, C, D65, E). For the determination of the colour coordinates of an illuminated surface, the standard illuminant D65, that corresponds to a daylight illumination taking into account the diffuse radiation of the sky, is used.

For the invention, the targeted colour coordinates (x,y) are located in the area represented in Figure 7 on the CIE 1931 xy-colour space and may range from yellowish-orange to reddish-orange where 0.4 - 0.33*x $\leq$ y $\leq$ 1.25*x.

The visible reflectance or daylight reflectance of the glazing is given by $R_{vis}$ which is the percentage of light striking the glazing that is reflected back. It indicates to what degree the glazing appears like a mirror, and thus provides information on the capability of the glazing to mask the technical part of modules and collectors. However, this value has to be low enough to permit a good solar transmittance and has thus been limited to 15% in the context of the invention.

As regards with colour stability, it has been showed that the CIE 1931 xy-colour space is not suited for comparing colour differences [20] and that the use of the CIE 1976 Lab colour space is more adapted. Then the colour differences $\Delta E^*$ between two different angles are simply be calculated as the Euclidean distance between two colour points whose colour coordinates are respectively $(a^*_1, b^*_1, L^*_1)$ and $(a^*_2, b^*_2, L^*_2)$ in the CIE 1976 Lab colour space.

This difference is calculated as:

$$\Delta E^* = \sqrt{(a^*_2 - a^*_1)^2 + (b^*_2 - b^*_1)^2 + (L^*_2 - L^*_1)^2} \qquad (1)$$

Luminance changes with viewing angle: L* value increases with angle of observation, meaning that the colour faded. Then in order to focus solely on the colour, the luminance is not taken into account for the calculation of $\Delta E^*$ and equation (1) is simplified as follows:

$$\Delta E^* = \sqrt{(a^*_2 - a^*_1)^2 + (b^*_2 - b^*_1)^2} \qquad (2)$$

The human eye is only capable of detecting colour differences at a certain threshold. The minimal detectable colour difference $\Delta E^*_{min}$ is given to be of approximately 2.3. From a practical standpoint, most people find it difficult to discern a $\Delta E^*$ of 3 or less, and a $\Delta E^*$ of 5 is quite subtle [21]. Nonetheless, the colour variations presented in the invention for different angles of reflection $\theta_r$ with respect to a normal angle, noted $\Delta E^*_{Norm}$ , can be considered as negligible for angles lower than 60°. Indeed, the $\Delta E^*_{Norm}$ values are generally lower than 10 and can be as low as 5.2 for an angle of 60°for the coating designs presented here.

For the calculation of the solar absorbance of thermal solar collectors, the solar spectrum at air mass 1.5 (AM1.5) is used conventionally. For the calculation of the solar transmittance $T_{sol}$ of the coloured cover glasses, the use of the spectrum AM1.5 is also adapted. For the invention, a maximal solar transmittance has to be reached in order to ensure a good efficiency of solar systems. These performances have been evaluated by calculating the efficiency losses as compared with a 4mm-thick extra-white non-coated glass. Concerning passive and ST systems, the information is directly accessible by the comparison of $T_{sol}$ of both coated and non-coated cover glasses and the efficiency loss due to the presence of the coating $L_{ST}$ is easily calculated.

For PV modules the process is a little bit more complicated. Here $T_{sol}$ has to be pondered by external quantum efficiency EQE ratio which relates to the response of a solar cell to the various wavelengths in the spectrum of light shining on the cell. As EQE depends on the nature of the used PV cells, efficiencies losses have been calculated for mono-crystalline silicon, microcrystalline silicon, amorphous silicon, CIGS and CdTe cells and are respectively designed by $L_{Si}$, $L_{mcSi}$, $L_{aSi}$, $L_{CIGS}$ and $L_{CdTe}$.

The EQE curves used for the calculation are extracted from refs. [22, 23] and correspond to commercially available PV solar cells, as follows:

- SunPower (efficiency under the global AM1.5 spectrum of 24.2 $\pm$ 0.7%) for mono-crystalline silicon cells,

- Schott Solar (efficiency under the global AM1.5 spectrum of 17.55 $\pm$ 0.5%) for microcrystalline silicon cells,

- Oerlikon Solar (efficiency under the global AM1.5 spectrum of 10.01 $\pm$ 0.3%) for amorphous silicon cells,

- NREL (efficiency under the global AM1.5 spectrum of 19.6 $\pm$ 0.6%) for CIGS cells,

- ASP Hangzhou (efficiency under the global AM1.5 spectrum of 12.5 $\pm$ 0.4%) for CdTe cells.

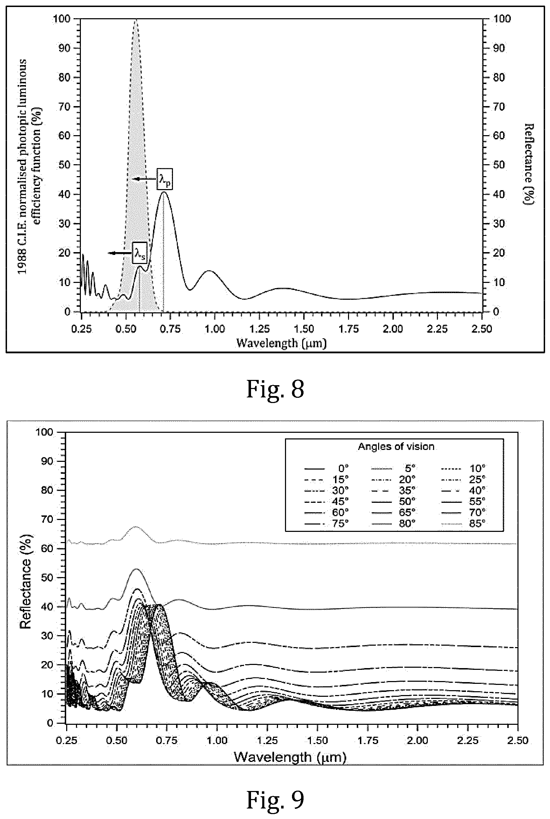

Results from numerous simulations have shown that only a limited number of designs permit to obtain a good stability of the colour with increasing angle of vision. All these designs are characterised by a particular shape of the reflectance curve. The combination of a reflectance peak situated at a wavelength of $\lambda_P$ and a shoulder situated at a wavelength of $\lambda_S < \lambda_P$ is the key of the colour stability (see Figure 8).

At normal incidence, the shoulder present at $\lambda_S$ (approx. 580nm) is responsible for the orange colour whereas the influence of the reflectance peak at $\lambda_P$ on the glazing colour is negligible. As a matter of facts, $\lambda_P$ is situated in the spectral region which is invisible to the human eye. This is illustrated by Figure 8, where the grey area, delimited by the photopic luminous efficiency function, corresponds to the visible part of the solar spectrum for the human eye.

With increasing angle of observation, most features in the spectra shift to smaller wavelengths (see Figure 9). Then the peak at $\lambda_P$ shifts into the visible range, thus compensating the loss of orange colour induced by the move of the shoulder to the left of the spectrum.

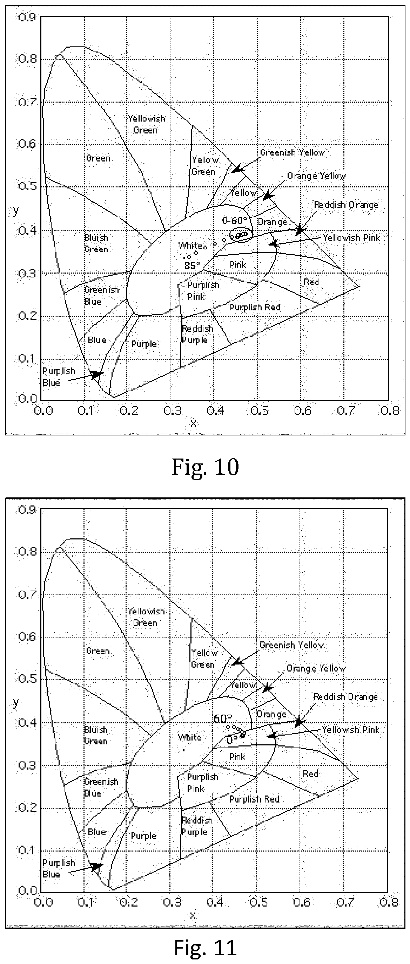

In respect with that particular shape of the reflectance curve, the typical resulting colour coordinates are stable for viewing angles up to 60° (see Figure 10).

The refractive indices of materials, $n_L$ and $n_H$ as well as the number and the thicknesses of individual layers building the multilayer stack are chosen in a way that phase shifts are compensated for varying angle.

A family of preferred designs is identified and is characterised as follow:

- The ratio of low and high the refractive indices $n_L/n_H$ of the chosen materials is comprised between 0.75 and 0.95.

- The numbers of individual layers is comprised between 5 and 9

- The thickness of individual layers is variable, depending on the targeted colour coordinates, the nature of the exit medium, the number of individual layers and the nature of the chosen materials. It typically ranges between a few manometers and 250 nm. Several examples are given in the following section.

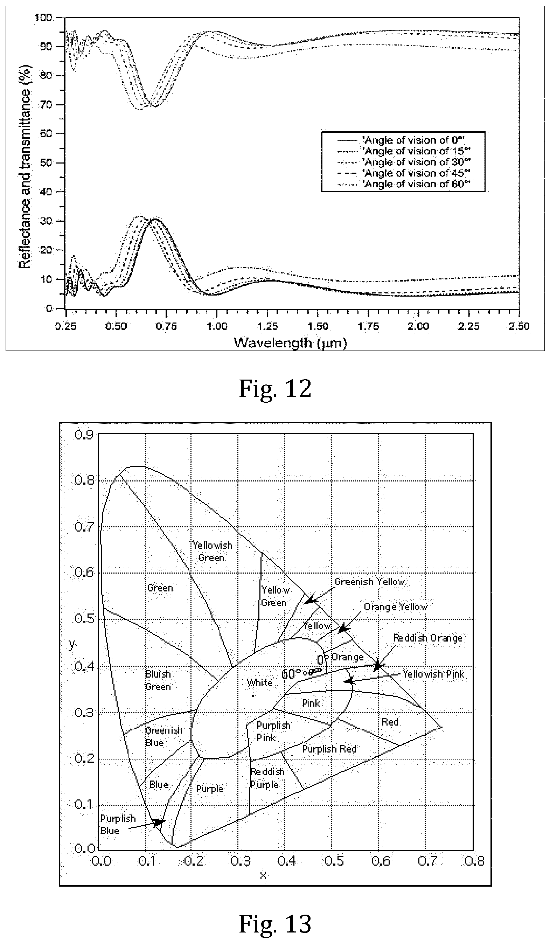

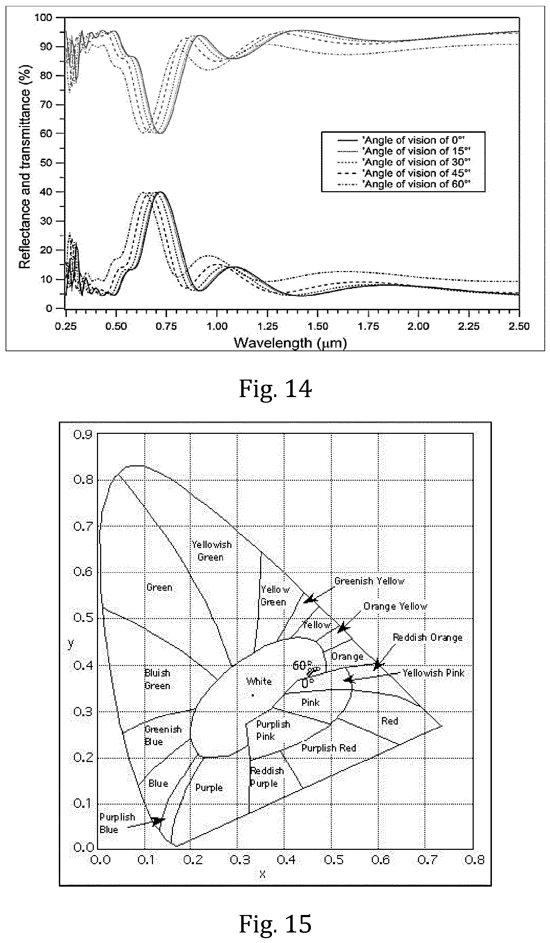

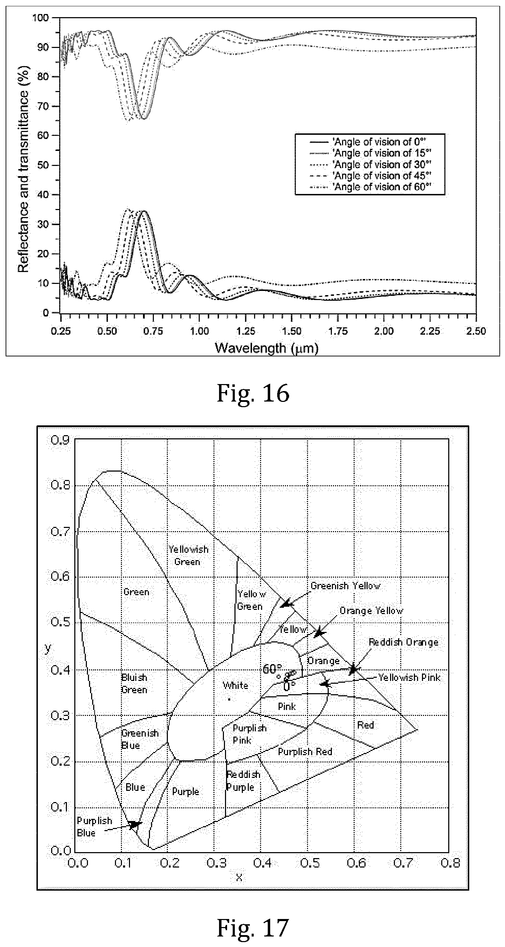

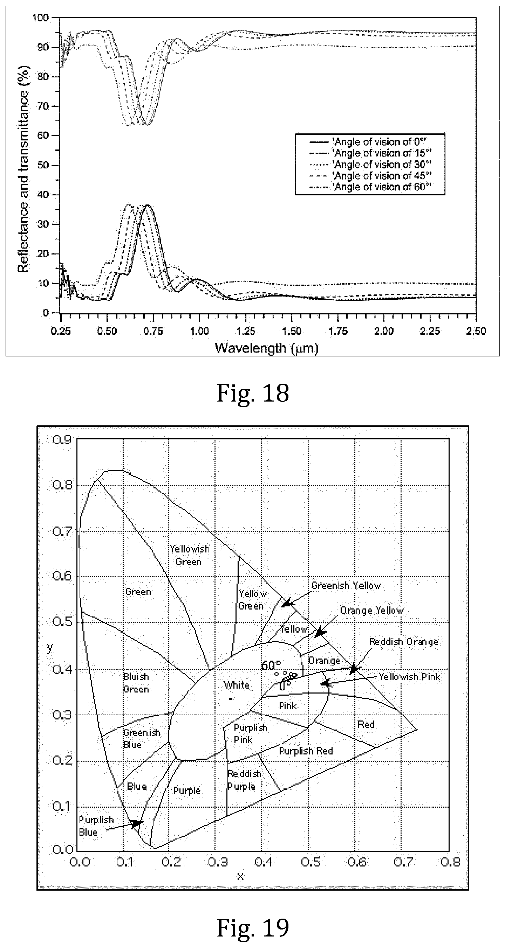

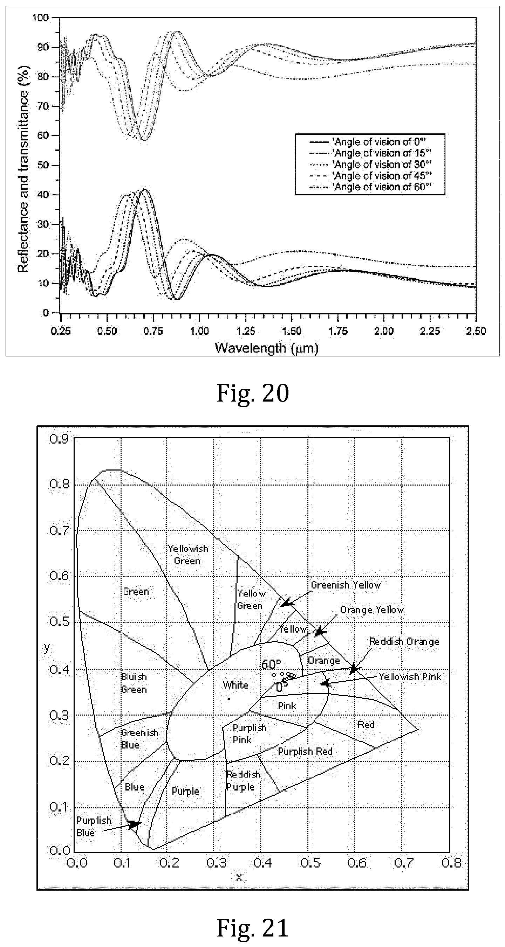

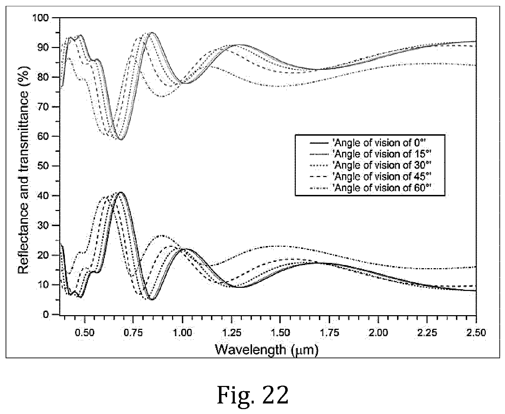

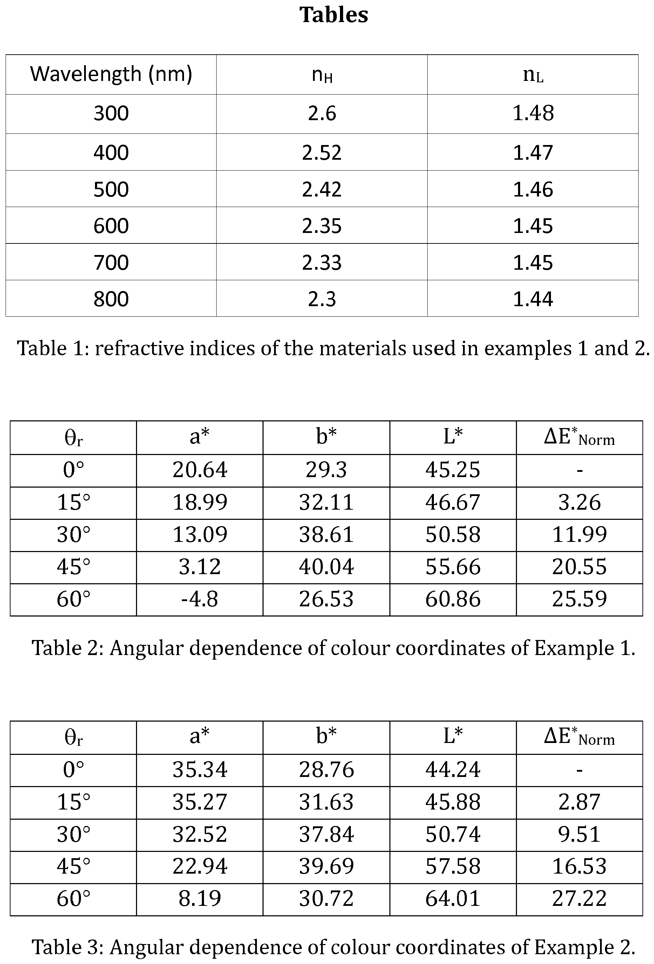

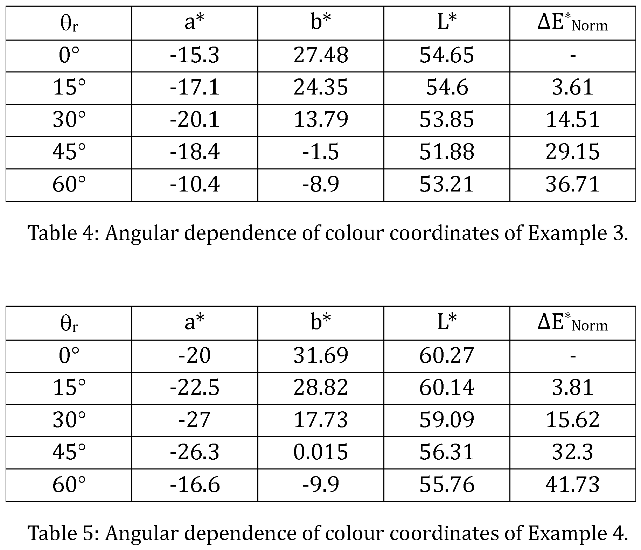

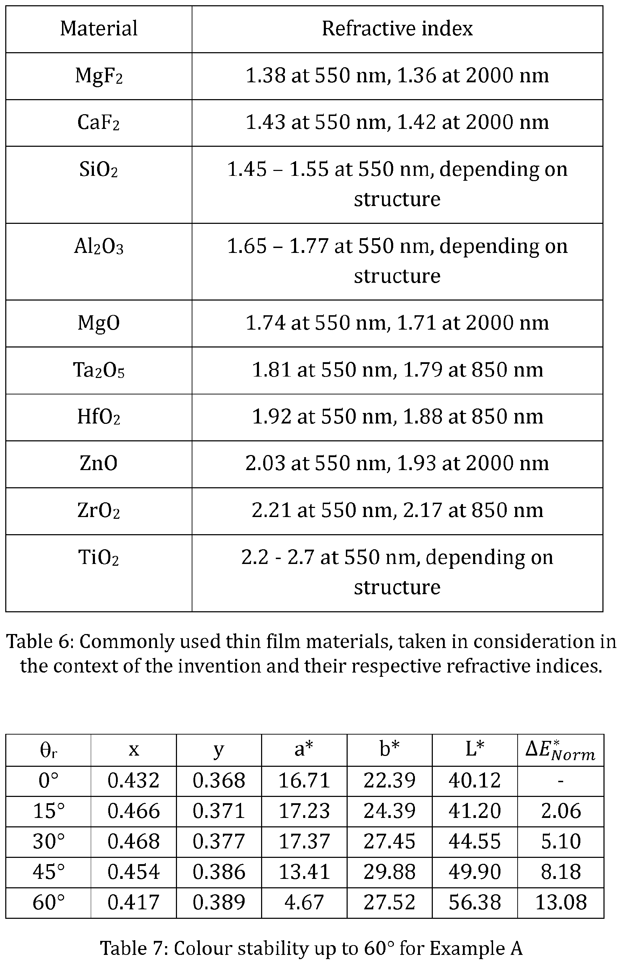

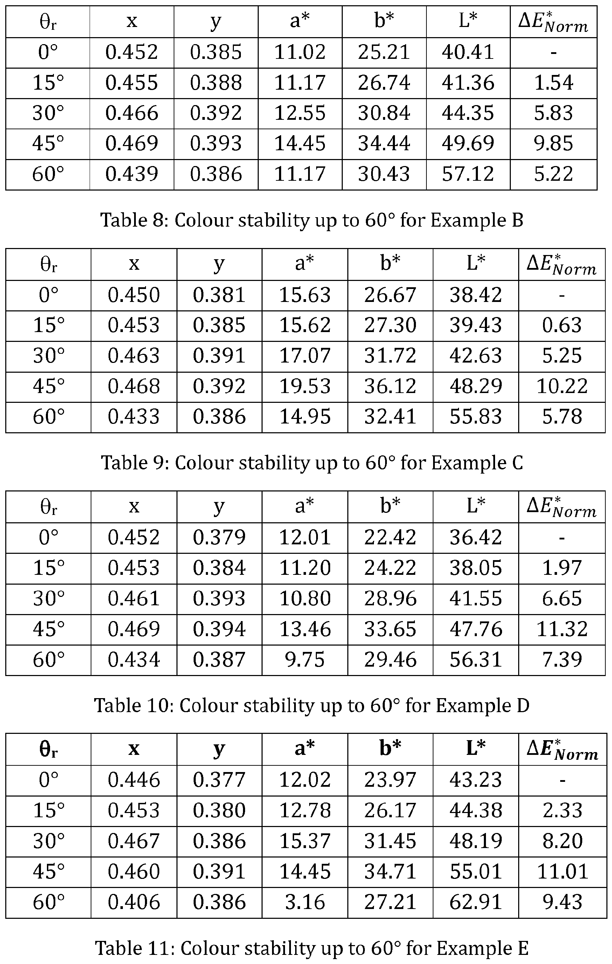

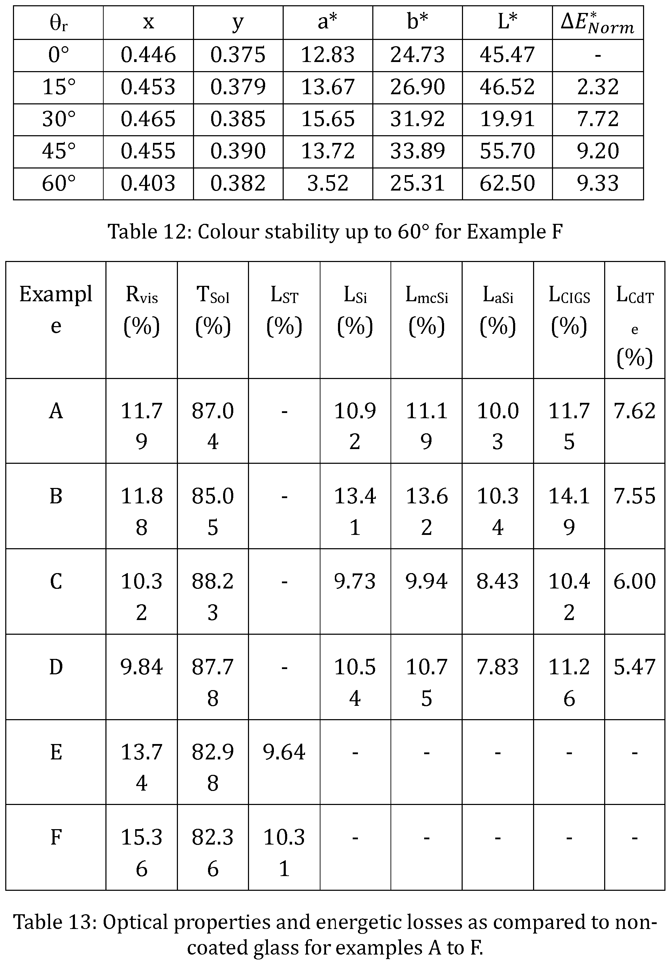

Coloured coating designs based on these criteria are given in Examples A, B, C, D, E and F (see figures 11 to 22 and tables 7 to 13).

**References**

[1] H.A. McLeod, Thin Film Optical Filters, American-Elsevier, New York, 1969.

[2] International Commission on Illumination CIE, 1986. Colorimetry. CIE Publication 15.2., 2nd ed., ISBN 3-900-734-00-3, Vienna

[3] A. G. Hestnes, Sol. Energy 67, Issues 4 — 6 (1999) 181.

[4] C. Roecker, P. Affolter, J. Bonvin, J. — B. Gay, A. N. Müller, Sol. Energy Mater. and Sol. Cells 36 (1995) 381.

[5] I. B. Hagemann, Architektonische Integration der Photovoltaik in die Gebäudehülle, PhD thesis accepted at the Technical University of Aachen, ISBN 3-481-01776-6, Müller, Köln, 2002.

[6] J. — L. Scartezzini, G. Courret, Sol. Energy 73 2 (2002) 123.

[7] W. Weiss, I. Stadler, Facade Integration — a new and promising opportunity for thermal solar collectors, Proceedings of the Industry Workshop of the IEA Solar Heating and Cooling Programme, Task 26 in Delft, The Netherlands, April 2, 2001.

[8] M. Born, E. Wolf, Principles of Optics, seventh ed., Cambridge University Press, Cambridge, MA, 1999.

[9] O.S. Heavens, Optical Properties of Thin SolidFilms, Butterworths, London, 1955.

[10] L. Holland, Vacuum Deposition of Thin Films, Chapman & Hall, London, 1956.

[11] H. Anders, Duünne Schichten für die Optik, Wissenschaftliche Verlagsgesellschaft, Stuttgart, 1965 (English translation Thin films in Optics, Focal Press, 1967).

[12] Z. Knittl, Optics of Thin Films, Wiley, London, 1976.

[13] H.A. Macleod, Thin-Film Optical Filters, Institute of Physics Publishing, Bristol and Philadelphia, 1986, 2001.

[14] A. Schüler, C. Roecker, J. Boudaden, P. Oelhafen, J.-L. Scartezzini, Solar Energy 79, 122 (2005)

[15] A. Schüler, J. Boudaden, P. Oelhafen, E. De Chambrier, C. Roecker, J.-L. Scartezzini, Solar Energy Materials & Solar Cells 89, 219 (2005)

[16] J. Boudaden, R.S. C. Ho, P. Oelhafen, A. Schüler, C. Roecker, J.-L. Scartezzini, Solar Energy Materials & Solar Cells 84, 225 (2004)

[17] A. Schüler, C. Roecker, J.-L. Scartezzini, J. Boudaden, I.R Videnovic, R.S. C. Ho, P. Oelhafen, Solar Energy Materials & Solar Cells 84, 241 (2004)

[18] A. Schüler, PCT, International publication number WO 3004/079278 A1, 16.09.2004.

[19]A. Schüler, D. Deepanshu, E. De Chambrier, C. Roecker, G. De Temmerman, P. Oelhafen, J.-L. Scartezzini, Solar Energy Materials & Solar Cells, num. 90 (2006)

[20] D.L. MacAdam, J. Opt. Soc. Am., 32 (1942)

[21] The Journal of Architectural Coatings, Technology Publishing, 02-03 (2006)

[22] M. A. Green, K. Emery, Y. Hishikawa, W. Warta, Prog. Photovolt: Res. Appl. 18 (2010)

[23] M. A. Green, K. Emery, Y. Hishikawa, W. Warta, Prog. Photovolt: Res. Appl. 19 (2011)

**Examples of coating designs**

**Example 1**

Air//4mm-thick glass //88 nm H /224 nm L // air
The materials H and L are included, assuming the refractive indices listed in the table 1.

**Example 2**

Air//4mm-thick glass // 104 nm H / 37 nm L / 103 nm H / 231 nm L // air
The materials H and L are included, assuming the refractive indices listed in the table 1.

**Example 3**

Air//4mm-thick glass // 83 nm H / 93 nm L / 83 nm H / 93 nm L / 83 nm H // air
The materials H and L are included, assuming the following refractive indices: $n_H$ = 1.65 and $n_L$ = 1.47.

**Example 4**

Air//30 nm H /136 nm L /222 nm H //4mm-thick glass //222 nm H /136 nm L /30 nm H //air The materials H and L are included, assuming the following refractive indices: $n_H$ = 1.8 and $n_L$ = 1.47.

**Example A**

Air//4mm-thick glass //88 nm H /89 nm L/90 nm H /89 nm L/119 nm H //polymer
The materials H and L are included, assuming the following refractive indices: $n_H$ = 2.0 and $n_L$ = 1.65.

**Example B**

Air//4mm-thick glass //119 nm H /123 nm L/95 nm H /89 nm L/88 nm H /86 nm L /99 nm H //polymer
The materials H and L are included, assuming the following refractive indices: $n_H$ = 2.0 and $n_L$ = 1.65.

**Example C**

Air//4mm-thick glass//115 nm H /116 nm L / 116 nm H / 89 nm L / 95 nm H / 96 nm L / 82 nm H / 87 nm L / 103 nm H //polymer
The materials H and L are included, assuming the following refractive indices: $n_H$ = 1.8 and $n_L$ = 1.65.

**Example D**

Air //4mm-thick glass // 115 nm H / 135 nm L / 122 nm H / 107 nm L / 102 nm H / 98 nm L / 95 nm H /97 nm L / 107 nm H //polymer
The materials H and L are included, assuming the following refractive indices: $n_H$ = 2.2 and $n_L$ = 1.47.

**Example E**

Air //4mm-thick glass // 123 nm H / 120 nm L / 109 nm H / 122 nm L / 79 nm H / 79 nm L / 120 nm H //air
The materials H and L are included, assuming the following refractive indices: $n_H$ = 2.2 and $n_L$ = 1.47.

**Example F**

Air //4mm-thick glass // 123 nm H /88 nm L / 115 nm H / 97 nm L / 73 nm H /74 nm L /114 nm H //air
The materials H and L are included, assuming the following refractive indices: $n_H$ = 1.8 and $n_L$ = 1.65.

**List of figure captions**

**Figure 1:**
Schematic drawing of a coloured glazing where a coloured multi-layered interferential coating is applied on the inner side. The coating reflects a colour and, as no absorption occurs in the coating, transmits the complementary spectrum.

**Figure 2:**
Angular dependency of 1931 CIE (x, y) colour coordinates under CIE-D65 illuminant of the coloured design given in Example 1.

**Figure 3:**
Angular dependency of 1931 CIE (x, y) colour coordinates under CIE-D65 illuminant of the coloured design given in Example 2.

**Figure 4:**
Angular dependency of 1931 CIE (x, y) colour coordinates under CIE-D65 illuminant of the coloured design given in Example 3.

**Figure 5:**
Angular dependency of 1931 CIE (x, y) colour coordinates under CIE-D65 illuminant of the coloured design given in Example 4.

**Figure 6:**
Models used for the simulations, depending of the considered solar system: (a) exit medium air for ST, PVT and passive systems, (b) exit medium polymer for PV systems. For both models, incident medium is almost iron-free glass.

**Figure 7:**
CIE 1931 xy-chromaticity diagram. The grey area defines the colour coordinates (x,y) targeted in the context of the innovation.

**Figure 8:**
Typical reflectance curve, with a reflectance peak and a shoulder respectively at $\lambda_P$ and $\lambda_S$, needed to obtain a good colour stability of the coating with increasing angle of reflection $\theta_r$. The grey area delimited by the 1988 C.I.E. normalised photopic luminous efficiency function represents the part of the solar spectrum which is visible for the human eye.

**Figure 9:**
Reflectance curves for different angles of reflection. With increasing angle, most features in the spectra shift to smaller wavelengths.

**Figure 10:**
Typical variation of colour coordinates in the CIE 1931 xy-colour space of the multi-layered interferential coatings presented in the context of the invention. Good colour stability is observed for angles up to 60°.

**Figure 11:**
Angular stability of 1931 CIE (x, y) colour coordinates under CIE-D65 illuminant of the coloured design given in Example A.

**Figure 12:**
Reflectance curves of the coating design given in Example A for various angles of reflection (from 0° to 60°).

**Figure 13:**
Angular stability of 1931 CIE (x, y) colour coordinates under CIE-D65 illuminant of the coloured design given in Example B.

**Figure 14:**
Reflectance curves of the coating design given in Example B for various angles of reflection (from 0° to 60°).

**Figure 15:**
Angular stability of 1931 CIE (x, y) colour coordinates under CIE-D65 illuminant of the coloured design given in Example C.

**Figure 16:**
Reflectance curves of the coating design given in Example C for various angles of reflection (from 0° to 60°).

**Figure 17:**
Angular stability of 1931 CIE (x, y) colour coordinates under CIE-D65 illuminant of the coloured design given in Example D.

**Figure 18:**
Reflectance curves of the coating design given in Example D for various angles of reflection (from 0° to 60°).

**Figure 19:**
Angular stability of 1931 CIE (x, y) colour coordinates under CIE-D65 illuminant of the coloured design given in Example E.

**Figure 20:**
Reflectance curves of the coating design given in Example E for various angles of reflection (from 0° to 60°).

**Figure 21:**
Angular stability of 1931 CIE (x, y) colour coordinates under CIE-D65 illuminant of the coloured design given in Example F.

**Figure 22:**
Reflectance curves of the coating design given in Example F for various angles of reflection (from 0° to 60°).

**Claims**

1. Solar glazing unit, suitable for photovoltaic modules and solar thermal collectors, comprising a substrate delimited by two main faces and a multi-layered interference filter also delimited by two main faces, one main face of said substrate being adapted to be in contact with an incident medium, the other main face being in contact with one of the main faces of said interference filter, the other main face of said interference filter being adapted to be in contact with an exit medium; said incident medium having a refractive index $n_{inc}$ = 1, said substrate having a refractive index $n_{substrate}$ defined as follows : $1.45 \leq n_{substrate} \leq 1.6$ at 550 nm, and said exit medium having a refractive index $n_{exit}$ = 1 or defined as follows $1.45 \leq n_{exit} \leq 1.6$ at 550 nm; and

   wherein the multi-layered interference filter of said unit includes a plurality of stacked alternating layers of high refractive index $n_H$ and low refractive index $n_L$ configured to produce a CIE colour stability $\Delta E^*_{Norm}$ , as observed under daylight illumination CIE D65 at higher angles of reflection $\theta_r$ corresponding to $\theta_r$ > 10° , that is less than 15 or $\Delta E^*_{Norm} \leq (\theta_r / 3°)$ for $10° < \theta_r \leq 60°$;

   wherein said multi-layered interference filter comprises one or more metal oxide layers with small absorption expressed by an extinction coefficient $(k) \leq 0.2$ for wavelengths $\lambda$ with 450 nm $\leq \lambda \leq$ 2500 nm, and wherein said multi-layered interference filter composed of the plurality of stacked alternating layers with refractive indices $n_L$ and $n_H$ has a ratio of the refractive indices $n_L/n_H$ of chosen materials between 0.75 and 0.95;
   **characterized in that** the plurality of stacked alternating layers of high and low refractive indices of the multi-layered interference filter is further configured to produce a visible colour of reflection of the solar glazing unit, visible to a human eye from the main face of the substrate adapted to be in contact with the incident medium and under daylight illumination CIE D65 at near-normal angle of reflection $\theta_r$ corresponding to $\theta_r \leq 10°$, **characterised by** CIE colour coordinates x, y defined by the following expression $0.4 - 0.33 * x \leq y \leq 1.25 * x$ corresponding to yellowish-orange to red-purplish colour reflection,
   and in that the plurality of stacked alternating layers of high and low refractive indices of the multi-layered interference filter is further configured to produce a reflectance spectrum comprising (i) a spectral reflectance peak $(\lambda_P)$ at near-normal observation angle of reflection corresponding to $\theta_r \leq 10°$ in a wavelength range $\geq 700$ nm and $\leq 1600$ nm and which shifts to lower wavelengths with increasing angle of observation; and (ii) a shoulder or a secondary peak $(\lambda_S)$ at a wavelength $\geq 500$nm and $\leq 780$nm and at a shorter wavelength to that of the

spectral reflectance peak ($\lambda_P$) and in a wavelength range of said visible colour of reflection of the solar glazing unit at near-normal angle of reflection corresponding to $\theta_r \leq 10°$.

2. Solar glazing unit according to anyone of the previous claims, wherein the multi-layered interference filter comprises multilayer interference stacks of non-absorbing transparent materials configured to provide a solar transmittance (Tsol) higher than 76 % at near normal incidence.

3. Solar glazing unit according to anyone of the previous claims wherein said multi-layered interference filter has a number of individual layers comprised between 5 and 9.

4. Solar glazing unit according to anyone of the previous claims wherein each layer of said multi-layered interference filter has a thickness which is less than 250 nm.

5. Solar glazing unit according to anyone of the previous claims wherein said multi-layered interference filter has 5 sub-layers composed by either a low refractive index material (L) with $1.5 \leq n_L \leq 1.8$ at 550 nm or a high refractive index material (H) with $1.8 \leq n_H \leq 2.2$ at 550 nm deposited on glass or polymer with $1.45 \leq n_{exit} \leq 1.6$ at 550 nm.

6. Solar glazing unit according to claim 3 wherein the general design of the unit is :
Incident medium // substrate //88 $\pm$ 12 nm of high refractive index material (H) /89 $\pm$ 12 nm of low refractive index material (L) /90 $\pm$ 12 nm of high refractive index material (H) /89 $\pm$ 12 nm of low refractive index material (L) /119 $\pm$ 12 nm of high refractive index material (H) // exit medium polymer

7. Solar glazing unit according to claim 3 wherein the general design of the unit is :
Incident medium // substrate // 119 $\pm$ 12 nm of high refractive index material (H) / 123 $\pm$ 12 nm of low refractive index material (L) / 95 $\pm$ 12 nm of high refractive index material (H) / 89 $\pm$ 5 nm of low refractive index material (L) / 88 $\pm$ 12 nm of high refractive index material (H) / 86 $\pm$ 12 nm of low refractive index material (L) / 99 $\pm$ 12 nm of high refractive index material (H) // exit medium polymer

8. Solar glazing unit according to claim 3 wherein the general design of the unit is :
Incident medium // substrate // 115 $\pm$ 12 nm of high refractive index material (H) / 116 $\pm$ 12 nm of low refractive index material (L) / 116 $\pm$ 12 nm of high refractive index material (H) / 89 $\pm$ 12 nm of low refractive index material (L) / 95 $\pm$ 12 nm of high refractive index material (H) / 96 $\pm$ 12 nm of low refractive index material (L) / 82 $\pm$ 12 nm of high refractive index material (H) / 87 $\pm$ 12 nm of low refractive index material (L) / 103 $\pm$ 12 nm of high refractive index material (H) // exit medium polymer

9. Solar glazing unit according to claim 3 wherein the general design of the unit is :
Incident medium // substrate // 123 $\pm$ 12 nm of high refractive index material (H) / 120 $\pm$ 12 nm of low refractive index material (L) / 109 $\pm$ 12 nm of high refractive index material (H) / 122 $\pm$ 12 nm of low refractive index material (L) / 79 $\pm$ 12 nm of high refractive index material (H) / 79 $\pm$ 12 nm of low refractive index material (L) / 120 $\pm$ 12 nm of high refractive index material (H) // exit medium air

10. Solar glazing unit according to claim 3 wherein the general design of the unit is :
Incident medium // substrate // 115 $\pm$ 12 nm of high refractive index material (H) / 135 $\pm$ 12 nm of low refractive index material (L) / 122 $\pm$ 12 nm of high refractive index material (H) / 107 $\pm$ 12 nm of low refractive index material (L) / 102 $\pm$ 12 nm of high refractive index material (H) / 98 $\pm$ 12 nm of low refractive index material (L) / 95 $\pm$ 12 nm of high refractive index material (H) / 97 $\pm$ 12 nm of low refractive index material (L) / 107 $\pm$ 12 nm of high refractive index material (H) // exit medium air

11. PV module comprising a solar glazing according to any previous claim.

12. Thermal solar collector comprising a solar glazing according to any one of previous claims 1 to 10.

13. Roof comprising PV modules according to previous claim 11.

14. Roof comprising thermal solar collectors according to previous claim 12.

15. Roof comprising PV modules and thermal solar collectors according to previous claims 11 and 12.

**Patentansprüche**

1. Solarverglasungseinheit, die für fotovoltaische Module und thermische Sonnenkollektoren geeignet ist und ein Substrat, das durch zwei Hauptflächen begrenzt ist, und ein mehrschichtiges Interferenzfilter umfasst, das ebenfalls durch zwei Hauptflächen begrenzt ist, wobei eine Hauptfläche des Substrats für Kontakt mit einem einfallenden Medium ausgelegt ist, die andere Hauptfläche mit einer der Hauptflächen des Interferenzfilters in Kontakt ist, die andere Hauptfläche des Interferenzfilters für Kontakt mit einem Austrittsmedium ausgelegt ist; das einfallende Medium einen Brechungsindex $n_{inc} = 1$ aufweist, das Substrat einen Brechungsindex $n_{substrate}$ aufweist, der definiert ist, wie folgt: $1,45 \leq n_{substrate} \leq 1,6$ bei 550 nm, und das Austrittsmedium einen Brechungsindex $n_{exit} = 1$ oder so definiert aufweist, wie folgt: $1,45 \leq n_{exit} \leq 1,6$ bei 550 nm; und

   wobei das mehrschichtige Interferenzfilter der Einheit eine Mehrzahl von gestapelten abwechselnden Schichten mit hohem Brechungsindex $n_H$ und niedrigem Brechungsindex $n_L$ umfasst und so ausgelegt ist, dass es eine CIE-Farbstabilität $\Delta E^*_{Norm}$, wie beobachtet unter Tageslichtbeleuchtung CIE D65 bei höheren Reflexionswinkeln $\theta_r$ entsprechend $\theta_r > 10°$, erzeugt, die niedriger als 15 ist, oder $\Delta E^*_{Norm} \leq (\theta_r / 3°)$ für $10° < \theta_r \leq 60°$;

   wobei das mehrschichtige Interferenzfilter eine oder mehrere Metalloxidschichten mit geringer Absorption, ausgedrückt durch einen Extinktionskoeffizienten $(k) \leq 0,2$, für Wellenlängen $\lambda$ mit $450$ nm $\leq \lambda \leq 2500$ nm umfasst, und wobei das mehrschichtige Interferenzfilter, das aus der Mehrzahl von gestapelten abwechselnden Schichten mit den Brechungsindizes $n_L$ und $n_H$ besteht, ein Verhältnis der Brechungsindizes $n_L/n_H$ von ausgewählten Materialien zwischen 0,75 und 0,95 aufweist;
   **dadurch gekennzeichnet, dass** die Mehrzahl von gestapelten abwechselnden Schichten mit hohem bzw. niedrigem Brechungsindex des mehrschichtigen Interferenzfilters ferner so ausgelegt ist, dass sie eine sichtbare Reflexionsfarbe der Solarverglasungseinheit erzeugt, die für ein menschliches Auge von der Hauptfläche des Substrats, die für Kontakt mit dem einfallenden Medium ausgelegt ist, und unter Tageslichtbeleuchtung CIE D65 bei einem annähernd senkrechten Reflexionswinkel $\theta_r$, der $\theta_r \leq 10°$ entspricht, sichtbar ist, **dadurch gekennzeichnet, dass** CIE-Farbkomponenten x, y durch den folgenden Ausdruck definiert sind: $0,4 - 0,33 * x \leq y \leq 1,25 * x$ und gelblichoranger bis rot-purpurner Farbreflexion entsprechen,
   und dadurch, dass die Mehrzahl von gestapelten abwechselnden Schichten mit hohem bzw. niedrigem Brechungsindex des mehrschichtigen Interferenzfilters ferner so ausgelegt ist, dass sie ein Reflexionsspektrum erzeugt, das (i) eine spektrale Reflexionsspitze ($\lambda_p$) bei einem annähernd senkrechten Beobachtungsreflexionswinkel, der in einem Wellenbereich $\geq 700$ nm und $\leq 1600$ nm $\theta_r \leq 10°$ entspricht und der sich mit zunehmendem Beobachtungswinkel zu niedrigeren Wellenlängen verschiebt; und (ii) eine Schulter oder eine sekundäre Spitze ($\lambda_s$) bei einer Wellenlänge $\geq 500$ nm und $\leq 780$ nm und bei einer kürzeren Wellenlänge als der der spektralen Reflexionsspitze ($\lambda_p$) und in einem Wellenlängenbereich der sichtbaren Reflexionsfarbe der Solarverglasungseinheit in einem annähernd senkrechten Reflexionswinkel umfasst, der $\theta_r \leq 10°$ entspricht.

2. Solarverglasungseinheit nach einem der vorhergehenden Ansprüche, wobei das mehrschichtige Interferenzfilter mehrschichtige Interferenzstapel aus nicht absorbierenden durchlässigen Materialien umfasst, um eine Sonnenstrahlungsdurchlässigkeit (Tsol) von über 76 % bei annähernd senkrechtem Einfall bereitzustellen.

3. Solarverglasungseinheit nach einem der vorhergehenden Ansprüche, wobei das mehrschichtige Interferenzfilter eine Anzahl von einzelnen Schichten aufweist, die zwischen 5 und 9 liegt.

4. Solarverglasungseinheit nach einem der vorhergehenden Ansprüche, wobei jede Schicht des mehrschichtigen Interferenzfilters eine Dicke aufweist, die geringer als 250 nm ist.

5. Solarverglasungseinheit nach einem der vorhergehenden Ansprüche, wobei das mehrschichtige Interferenzfilter 5 Teilschichten aufweist, die entweder aus einem Material mit niedrigem Brechungsindex (L) von $1,5 \leq n_L \leq 1,8$ bei 550 nm oder aus einem Material mit hohem Brechungsindex (H) von $1,8 \leq n_H \leq 2,2$ bei 550 nm bestehen und auf Glas oder Polymer mit $1,45 \leq n_{exit} \leq 1,6$ bei 550 nm abgeschieden sind.

6. Solarverglasungseinheit nach Anspruch 3, wobei der allgemeine Aufbau der Einheit ist, wie folgt:
   Einfallendes Medium // Substrat // $88 \pm 12$ nm von Material mit hohem Brechungsindex (H) / $89 \pm 12$ nm von Material mit niedrigem Brechungsindex (L) / $90 \pm 12$ nm von Material mit hohem Brechungsindex (H) / $89 \pm 12$ nm von Material mit niedrigem Brechungsindex (L) / $119 \pm 12$ nm von Material mit hohem Brechungsindex (H) // Austrittsmedium Polymer

**7.** Solarverglasungseinheit nach Anspruch 3, wobei die allgemeine Aufbau der Einheit ist, wie folgt: Einfallendes Medium // Substrat // 119 ± 12 nm von Material mit hohem Brechungsindex (H) / 123 ± 12 nm von Material mit niedrigem Brechungsindex (L) / 95 ± 12 nm von Material mit hohem Brechungsindex (H) / 89 ± 5 nm von Material mit niedrigem Brechungsindex (L) / 88 ± 12 nm von Material mit hohem Brechungsindex (H) / 86 ± 12 nm von Material mit niedrigem Brechungsindex (L) / 99 ± 12 nm von Material mit hohem Brechungsindex (H) // Austrittsmedium Polymer.

**8.** Solarverglasungseinheit nach Anspruch 3, wobei der allgemeine Aufbau der Einheit ist, wie folgt: Einfallendes Medium // Substrat // 115 ± 12 nm von Material mit hohem Brechungsindex (H) / 116 ± 12 nm von Material mit niedrigem Brechungsindex (L) / 116 ± 12 nm von Material mit hohem Brechungsindex (H) / 89 ± 12 nm von Material mit niedrigem Brechungsindex (L) / 95 ± 12 nm von Material mit hohem Brechungsindex (H) / 96 ± 12 nm von Material mit niedrigem Brechungsindex (L) / 82 ± 12 nm von Material mit hohem Brechungsindex (H) / 87 ± 12 nm von Material mit niedrigem Brechungsindex (L) / 103 ± 12 nm von Material mit hohem Brechungsindex (H) // Austrittsmedium Polymer.

**9.** Solarverglasungseinheit nach Anspruch 3, wobei der allgemeine Aufbau der Einheit ist, wie folgt: Einfallendes Medium // Substrat // 123 ± 12 nm von Material mit hohem Brechungsindex (H) / 120 ± 12 nm von Material mit niedrigem Brechungsindex (L) / 109 ± 12 nm von Material mit hohem Brechungsindex (H) / 122 ± 12 nm von Material mit niedrigem Brechungsindex (L) / 79 ± 12 nm von Material mit hohem Brechungsindex (H) / 79 ± 12 nm von Material mit niedrigem Brechungsindex (L) / 120 ± 12 nm von Material mit hohem Brechungsindex (H) // Austrittsmedium Luft.

**10.** Solarverglasungseinheit nach Anspruch 3, wobei der allgemeine Aufbau der Einheit ist, wie folgt: Einfallendes Medium // Substrat // 115 ± 12 nm von Material mit hohem Brechungsindex (H) / 135 ± 12 nm von Material mit niedrigem Brechungsindex (L) / 122 ± 12 nm von Material mit hohem Brechungsindex (H) / 107 ± 12 nm von Material mit niedrigem Brechungsindex (L) / 102 ± 12 nm von Material mit hohem Brechungsindex (H) / 98 ± 12 nm von Material mit niedrigem Brechungsindex (L) / 95 ± 12 nm von Material mit hohem Brechungsindex (H) / 97 ± 12 nm von Material mit niedrigem Brechungsindex (L) / 107 ± 12 nm von Material mit hohem Brechungsindex (H) // Austrittsmedium Luft.

**11.** PV-Modul, umfassend eine Solarverglasung nach einem der vorhergehenden Ansprüche.

**12.** Thermischer Sonnenkollektor, umfassend eine Solarverglasung nach einem der Ansprüche 1 bis 10.

**13.** Dach, umfassend PV-Module nach Anspruch 11.

**14.** Dach, umfassend thermische Sonnenkollektoren nach Anspruch 12.

**15.** Dach, umfassend PV-Module und thermische Sonnenkollektoren nach Anspruch 11 und 12.

**Revendications**

**1.** Unité de vitrage solaire, appropriée pour des modules photovoltaïques et des collecteurs solaires thermiques, comprenant un substrat délimité par deux faces principales et un filtre interférentiel multicouche également délimité par deux faces principales, une face principale dudit substrat étant adaptée pour être en contact avec un milieu incident, l'autre face principale étant en contact avec une des faces principales dudit filtre interférentiel, l'autre face principale dudit filtre interférentiel étant adaptée pour être en contact avec un milieu de sortie, ledit milieu incident ayant un indice de réfraction $n_{inc} = 1$, ledit substrat ayant un indice de réfraction $n_{substrate}$ défini comme suit : 1,45 $\leq n_{substrate} \leq$ 1,6 à 550 nm, et ledit milieu de sortie ayant un indice de réfraction $n_{exit} = 1$ ou défini comme suit : 1,45 $\leq n_{exit} \leq$ 1,6 à 550 nm ; et

le filtre interférentiel multicouche de ladite unité comportant une pluralité de couches à fort indice de réfraction $n_H$ et à faible indice de réfraction $n_L$ alternées empilées configurée pour produire une stabilité de couleur CIE $\Delta E^*_{Norm}$, telle qu'observée sous éclairage de jour CIE D65 à des angles de réflexion $\theta_r$ supérieurs correspondant à $\theta_r > 10°$, qui est inférieure à 15 ou $\Delta E^*_{Norm} \leq \theta_r/3°$) pour $10° < \theta_r \leq 60°$ ;

ledit filtre interférentiel multicouche comprenant une ou plusieurs couches d'oxyde métallique avec une faible absorption exprimée par un coefficient d'extinction (k) ≤ 0,2 pour des longueurs d'onde λ avec 450 nm ≤ λ ≤ 2500 nm, et ledit filtre interférentiel multicouche composé de la pluralité de couches alternées empilées avec les indices de réfraction $n_L$ et $n_H$ ayant un rapport des indices de réfraction $n_L/n_H$ de matériaux choisis entre 0,75 et 0,95 ;

**caractérisée en ce que** la pluralité de couches à indices de réfraction fort et faible alternées empilées du filtre interférentiel multicouche est également configurée pour produire une couleur visible de réflexion de l'unité de vitrage solaire, visible pour un œil humain depuis la face principale du substrat adaptée pour être en contact avec le milieu incident et sous éclairage de jour CIE D65 à un angle de réflexion $\theta_r$ proche de la normale, correspondant à $\theta_r \le 10°$, **caractérisée par** des coordonnées de couleur CIE x,y définies par l'expression suivante : 0,4 — 0,33*x ≤ y ≤ 1,25*x correspondant à une réflexion de couleur orange jaunâtre à rouge pourpre, et en ce que la pluralité de couches à indices de réfraction fort et faible alternées empilées du filtre interférentiel multicouche est également configurée pour produire un spectre de réflectance comprenant (i) un pic de réflectance spectrale ($\lambda_P$) à un angle de réflexion d'observation proche de la normale correspondant à $\theta_r \le 10°$ dans une gamme de longueurs d'onde ≥ 700 nm et ≤ 1600 nm et qui se décale vers des longueurs d'onde plus courtes avec un angle d'observation croissant ; et (ii) un épaulement ou un pic secondaire ($\lambda_S$) à une longueur d'onde ≤ 500 nm et ≤ 780 nm et à une longueur d'onde plus courte que celle du pic de réflectance spectrale ($\lambda_P$) et dans une gamme de longueurs d'onde de ladite couleur visible de réflexion de l'unité de vitrage solaire à un angle de réflexion proche de la normale correspondant à $\theta_r \le 10°$.

2. Unité de vitrage solaire selon l'une quelconque des revendications précédentes, dans laquelle le filtre interférentiel multicouche comprend des empilements interférentiels multicouches de matériaux transparents non absorbants configurés pour fournir une transmittance solaire ($T_{sol}$) supérieure à 76 % en incidence proche de la normale.

3. Unité de vitrage solaire selon l'une quelconque des revendications précédentes dans laquelle ledit filtre interférentiel multicouche a un nombre de couches individuelles compris entre 5 et 9.

4. Unité de vitrage solaire selon l'une quelconque des revendications précédentes dans laquelle chaque couche dudit filtre interférentiel multicouche a une épaisseur qui est inférieure à 250 nm.

5. Unité de vitrage solaire selon l'une quelconque des revendications précédentes dans laquelle ledit filtre interférentiel multicouche a 5 sous-couches composées soit d'un matériau à faible indice de réfraction (L) avec $1,5 \le n_L \le 1,8$ à 550 nm, soit d'un matériau à fort indice de réfraction (H) avec $1,8 \le n_H \le 2,2$ à 550 nm, déposé sur du verre ou un polymère avec $1,45 \le n_{exit} \le 1,6$ à 550 nm.

6. Unité de vitrage solaire selon la revendication 3, la conception générale de l'unité étant : milieu incident // substrat // 88 ± 12 nm de matériau à fort indice de réfraction (H) / 89 ± 12 nm de matériau à faible indice de réfraction (L) / 90 ± 12 nm de matériau à fort indice de réfraction (H) / 89 ± 12 nm de matériau à faible indice de réfraction (L) / 119 ± 12 nm de matériau à fort indice de réfraction (H) // polymère du milieu de sortie.

7. Unité de vitrage solaire selon la revendication 3, la conception générale de l'unité étant : milieu incident // substrat // 119 ± 12 nm de matériau à fort indice de réfraction (H) / 123 ± 12 nm de matériau à faible indice de réfraction (L) / 95 ± 12 nm de matériau à fort indice de réfraction (H) / 89 ± 5 nm de matériau à faible indice de réfraction (L) / 88 ± 12 nm de matériau à fort indice de réfraction (H) / 86 ± 12 nm de matériau à faible indice de réfraction (L) / 99 ± 12 nm de matériau à fort indice de réfraction (H) // polymère du milieu de sortie.

8. Unité de vitrage solaire selon la revendication 3, la conception générale de l'unité étant : milieu incident // substrat // 115 ± 12 nm de matériau à fort indice de réfraction (H) / 116 ± 12 nm de matériau à faible indice de réfraction (L) / 116 ± 12 nm de matériau à fort indice de réfraction (H) / 89 ± 12 nm de matériau à faible indice de réfraction (L) / 95 ± 12 nm de matériau à fort indice de réfraction (H) / 96 ± 12 nm de matériau à faible indice de réfraction (L) / 82 ± 12 nm de matériau à fort indice de réfraction (H) / 87 ± 12 nm de matériau à faible indice de réfraction (L) / 103 ± 12 nm de matériau à fort indice de réfraction (H) // polymère du milieu de sortie.

9. Unité de vitrage solaire selon la revendication 3, la conception générale de l'unité étant : milieu incident // substrat // 123 ± 12 nm de matériau à fort indice de réfraction (H) / 120 ± 12 nm de matériau à faible indice de réfraction (L) / 109 ± 12 nm de matériau à fort indice de réfraction (H) / 122 ± 12 nm de matériau à faible indice de réfraction (L) / 79 ± 12 nm de matériau à fort indice de réfraction (H) / 79 ± 12 nm de matériau à faible indice de réfraction (L) / 120 ± 12 nm de matériau à fort indice de réfraction (H) // air du milieu de sortie.

**10.** Unité de vitrage solaire selon la revendication 3, la conception générale de l'unité étant : milieu incident // substrat // 115 $\pm$ 12 nm de matériau à fort indice de réfraction (H) / 135 $\pm$ 12 nm de matériau à faible indice de réfraction (L) / 122 $\pm$ 12 nm de matériau à fort indice de réfraction (H) / 107 $\pm$ 12 nm de matériau à faible indice de réfraction (L) / 102 $\pm$ 12 nm de matériau à fort indice de réfraction (H) / 98 $\pm$ 12 nm de matériau à faible indice de réfraction (L) / 95 $\pm$ 12 nm de matériau à fort indice de réfraction (H) / 97 $\pm$ 12 nm de matériau à faible indice de réfraction (L) / 107 $\pm$ 12 nm de matériau à fort indice de réfraction (H) // air du milieu de sortie.

**11.** Module PV comprenant un vitrage solaire selon une quelconque revendication précédente.

**12.** Collecteur solaire thermique comprenant un vitrage solaire selon l'une quelconque des revendications 1 à 10 précédentes.

**13.** Toit comprenant des modules PV selon la revendication 11 précédente.

**14.** Toit comprenant des collecteurs solaires thermiques selon la revendication 12 précédente.

**15.** Toit comprenant des modules PV et des collecteurs solaires thermiques selon les revendications 11 et 12 précédentes.

Fig. 0

Fig. 1

Fig. 2

Fig. 3

Fig. 4

Fig. 5

Fig. 6

Fig. 7

Fig. 8

Fig. 9

Fig. 10

Fig. 11

Fig. 12

Fig. 13

Fig. 14

Fig. 15

Fig. 16

Fig. 17

Fig. 18

Fig. 19

Fig. 20

Fig. 21

Fig. 22

# Tables

| Wavelength (nm) | $n_H$ | $n_L$ |
|---|---|---|
| 300 | 2.6 | 1.48 |
| 400 | 2.52 | 1.47 |
| 500 | 2.42 | 1.46 |
| 600 | 2.35 | 1.45 |
| 700 | 2.33 | 1.45 |
| 800 | 2.3 | 1.44 |

Table 1: refractive indices of the materials used in examples 1 and 2.

| $\theta_r$ | a* | b* | L* | $\Delta E^*_{Norm}$ |
|---|---|---|---|---|
| 0° | 20.64 | 29.3 | 45.25 | - |
| 15° | 18.99 | 32.11 | 46.67 | 3.26 |
| 30° | 13.09 | 38.61 | 50.58 | 11.99 |
| 45° | 3.12 | 40.04 | 55.66 | 20.55 |
| 60° | -4.8 | 26.53 | 60.86 | 25.59 |

Table 2: Angular dependence of colour coordinates of Example 1.

| $\theta_r$ | a* | b* | L* | $\Delta E^*_{Norm}$ |
|---|---|---|---|---|
| 0° | 35.34 | 28.76 | 44.24 | - |
| 15° | 35.27 | 31.63 | 45.88 | 2.87 |
| 30° | 32.52 | 37.84 | 50.74 | 9.51 |
| 45° | 22.94 | 39.69 | 57.58 | 16.53 |
| 60° | 8.19 | 30.72 | 64.01 | 27.22 |

Table 3: Angular dependence of colour coordinates of Example 2.

| $\theta_r$ | a* | b* | L* | $\Delta E^*_{Norm}$ |
|---|---|---|---|---|
| 0° | -15.3 | 27.48 | 54.65 | - |
| 15° | -17.1 | 24.35 | 54.6 | 3.61 |
| 30° | -20.1 | 13.79 | 53.85 | 14.51 |
| 45° | -18.4 | -1.5 | 51.88 | 29.15 |
| 60° | -10.4 | -8.9 | 53.21 | 36.71 |

Table 4: Angular dependence of colour coordinates of Example 3.

| $\theta_r$ | a* | b* | L* | $\Delta E^*_{Norm}$ |
|---|---|---|---|---|
| 0° | -20 | 31.69 | 60.27 | - |
| 15° | -22.5 | 28.82 | 60.14 | 3.81 |
| 30° | -27 | 17.73 | 59.09 | 15.62 |
| 45° | -26.3 | 0.015 | 56.31 | 32.3 |
| 60° | -16.6 | -9.9 | 55.76 | 41.73 |

Table 5: Angular dependence of colour coordinates of Example 4.

| Material | Refractive index |
|---|---|
| MgF$_2$ | 1.38 at 550 nm, 1.36 at 2000 nm |
| CaF$_2$ | 1.43 at 550 nm, 1.42 at 2000 nm |
| SiO$_2$ | 1.45 – 1.55 at 550 nm, depending on structure |
| Al$_2$O$_3$ | 1.65 – 1.77 at 550 nm, depending on structure |
| MgO | 1.74 at 550 nm, 1.71 at 2000 nm |
| Ta$_2$O$_5$ | 1.81 at 550 nm, 1.79 at 850 nm |
| HfO$_2$ | 1.92 at 550 nm, 1.88 at 850 nm |
| ZnO | 2.03 at 550 nm, 1.93 at 2000 nm |
| ZrO$_2$ | 2.21 at 550 nm, 2.17 at 850 nm |
| TiO$_2$ | 2.2 - 2.7 at 550 nm, depending on structure |

Table 6: Commonly used thin film materials, taken in consideration in the context of the invention and their respective refractive indices.

| $\theta_r$ | x | y | a* | b* | L* | $\Delta E^*_{Norm}$ |
|---|---|---|---|---|---|---|
| 0° | 0.432 | 0.368 | 16.71 | 22.39 | 40.12 | - |
| 15° | 0.466 | 0.371 | 17.23 | 24.39 | 41.20 | 2.06 |
| 30° | 0.468 | 0.377 | 17.37 | 27.45 | 44.55 | 5.10 |
| 45° | 0.454 | 0.386 | 13.41 | 29.88 | 49.90 | 8.18 |
| 60° | 0.417 | 0.389 | 4.67 | 27.52 | 56.38 | 13.08 |

Table 7: Colour stability up to 60° for Example A

| $\theta_r$ | x | y | a* | b* | L* | $\Delta E^*_{Norm}$ |
|---|---|---|---|---|---|---|
| 0° | 0.452 | 0.385 | 11.02 | 25.21 | 40.41 | - |
| 15° | 0.455 | 0.388 | 11.17 | 26.74 | 41.36 | 1.54 |
| 30° | 0.466 | 0.392 | 12.55 | 30.84 | 44.35 | 5.83 |
| 45° | 0.469 | 0.393 | 14.45 | 34.44 | 49.69 | 9.85 |
| 60° | 0.439 | 0.386 | 11.17 | 30.43 | 57.12 | 5.22 |

Table 8: Colour stability up to 60° for Example B

| $\theta_r$ | x | y | a* | b* | L* | $\Delta E^*_{Norm}$ |
|---|---|---|---|---|---|---|
| 0° | 0.450 | 0.381 | 15.63 | 26.67 | 38.42 | - |
| 15° | 0.453 | 0.385 | 15.62 | 27.30 | 39.43 | 0.63 |
| 30° | 0.463 | 0.391 | 17.07 | 31.72 | 42.63 | 5.25 |
| 45° | 0.468 | 0.392 | 19.53 | 36.12 | 48.29 | 10.22 |
| 60° | 0.433 | 0.386 | 14.95 | 32.41 | 55.83 | 5.78 |

Table 9: Colour stability up to 60° for Example C

| $\theta_r$ | x | y | a* | b* | L* | $\Delta E^*_{Norm}$ |
|---|---|---|---|---|---|---|
| 0° | 0.452 | 0.379 | 12.01 | 22.42 | 36.42 | - |
| 15° | 0.453 | 0.384 | 11.20 | 24.22 | 38.05 | 1.97 |
| 30° | 0.461 | 0.393 | 10.80 | 28.96 | 41.55 | 6.65 |
| 45° | 0.469 | 0.394 | 13.46 | 33.65 | 47.76 | 11.32 |
| 60° | 0.434 | 0.387 | 9.75 | 29.46 | 56.31 | 7.39 |

Table 10: Colour stability up to 60° for Example D

| $\theta_r$ | x | y | a* | b* | L* | $\Delta E^*_{Norm}$ |
|---|---|---|---|---|---|---|
| 0° | 0.446 | 0.377 | 12.02 | 23.97 | 43.23 | - |
| 15° | 0.453 | 0.380 | 12.78 | 26.17 | 44.38 | 2.33 |
| 30° | 0.467 | 0.386 | 15.37 | 31.45 | 48.19 | 8.20 |
| 45° | 0.460 | 0.391 | 14.45 | 34.71 | 55.01 | 11.01 |
| 60° | 0.406 | 0.386 | 3.16 | 27.21 | 62.91 | 9.43 |

Table 11: Colour stability up to 60° for Example E

| $\theta_r$ | x | y | a* | b* | L* | $\Delta E^*_{Norm}$ |
|------|-------|-------|-------|-------|-------|-------|
| 0° | 0.446 | 0.375 | 12.83 | 24.73 | 45.47 | - |
| 15° | 0.453 | 0.379 | 13.67 | 26.90 | 46.52 | 2.32 |
| 30° | 0.465 | 0.385 | 15.65 | 31.92 | 19.91 | 7.72 |
| 45° | 0.455 | 0.390 | 13.72 | 33.89 | 55.70 | 9.20 |
| 60° | 0.403 | 0.382 | 3.52 | 25.31 | 62.50 | 9.33 |

Table 12: Colour stability up to 60° for Example F

| Example | $R_{vis}$ (%) | $T_{Sol}$ (%) | $L_{ST}$ (%) | $L_{Si}$ (%) | $L_{mcSi}$ (%) | $L_{aSi}$ (%) | $L_{CIGS}$ (%) | $L_{CdTe}$ (%) |
|------|------|------|------|------|------|------|------|------|
| A | 11.79 | 87.04 | - | 10.92 | 11.19 | 10.03 | 11.75 | 7.62 |
| B | 11.88 | 85.05 | - | 13.41 | 13.62 | 10.34 | 14.19 | 7.55 |
| C | 10.32 | 88.23 | - | 9.73 | 9.94 | 8.43 | 10.42 | 6.00 |
| D | 9.84 | 87.78 | - | 10.54 | 10.75 | 7.83 | 11.26 | 5.47 |
| E | 13.74 | 82.98 | 9.64 | - | - | - | - | - |
| F | 15.36 | 82.36 | 10.31 | - | - | - | - | - |

Table 13: Optical properties and energetic losses as compared to non-coated glass for examples A to F.

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 2011268941 A1
- WO 2004079278 A1
- EP 0983972 A2
- EP 1176434 A1
- WO 3004079278 A1, A. Schüler

### Non-patent literature cited in the description

- **H.A. MCLEOD.** Thin Film Optical Filters. American-Elsevier, 1969
- Colorimetry. International Commission on Illumination CIE. CIE, 1986
- **A. G. HESTNES.** *Sol. Energy,* 1999, vol. 67 (4 — 6), 181
- **C. ROECKER ; P. AFFOLTER ; J. BONVIN ; J. — B. GAY ; A. N. MÜLLER.** *Sol. Energy Mater. and Sol. Cells,* 1995, vol. 36, 381
- Architektonische Integration der Photovoltaik in die Gebäudehülle. **I. B. HAGEMANN.** PhD thesis. Technical University of Aachen, 2002
- **J. — L. SCARTEZZINI ; G. COURRET.** *Sol. Energy,* 2002, vol. 73 (2), 123
- **W. WEISS ; I. STADLER.** Facade Integration — a new and promising opportunity for thermal solar collectors. *Proceedings of the Industry Workshop of the IEA Solar Heating and Cooling Programme,* 02 April 2001
- **M. BORN ; E. WOLF.** Principles of Optics. Cambridge University Press, 1999
- **O.S. HEAVENS.** Optical Properties of Thin Solid-Films. Butterworths, 1955
- **L. HOLLAND.** Vacuum Deposition of Thin Films. Chapman & Hall, 1956
- **H. ANDERS.** Duünne Schichten für die Optik. Wissenschaftliche Verlagsgesellschaft, 1965
- English translation Thin films in Optics. Focal Press, 1967
- **Z. KNITTL.** Optics of Thin Films. Wiley, 1976
- **H.A. MACLEOD.** Thin-Film Optical Filters. Institute of Physics Publishing, 1986
- **A. SCHÜLER ; C. ROECKER ; J. BOUDADEN ; P. OELHAFEN ; J.-L. SCARTEZZINI.** *Solar Energy,* 2005, vol. 79, 122
- **A. SCHÜLER ; J. BOUDADEN ; P. OELHAFEN ; E. DE CHAMBRIER ; C. ROECKER ; J.-L. SCARTEZZINI.** *Solar Energy Materials & Solar Cells,* 2005, vol. 89, 219
- **J. BOUDADEN ; R.S. C. HO ; P. OELHAFEN ; A. SCHÜLER ; C. ROECKER ; J.-L. SCARTEZZINI.** *Solar Energy Materials & Solar Cells,* 2004, vol. 84, 225
- **A. SCHÜLER ; C. ROECKER ; J.-L. SCARTEZZINI ; J. BOUDADEN ; I.R VIDENOVIC ; R.S. C. HO ; P. OELHAFEN.** *Solar Energy Materials & Solar Cells,* 2004, vol. 84, 241
- **A. SCHÜLER ; D. DEEPANSHU ; E. DE CHAMBRIER ; C. ROECKER ; G. DE TEMMERMAN ; P. OELHAFEN ; J.-L. SCARTEZZINI.** *Solar Energy Materials & Solar Cells,* 2006
- **D.L. MACADAM.** *J. Opt. Soc. Am.,* 1942, 32
- The Journal of Architectural Coatings. Technology Publishing, 2006, 02-03
- **M. A. GREEN ; K. EMERY ; Y. HISHIKAWA ; W. WARTA.** *Prog. Photovolt: Res. Appl.,* 2010, 18
- **M. A. GREEN ; K. EMERY ; Y. HISHIKAWA ; W. WARTA.** *Prog. Photovolt: Res. Appl.,* 2011, vol. 19